# EUROPEAN PATENT APPLICATION

(11) **EP 4 550 415 A1**
(43) Date of publication of application: **07.05.2025**
(21) Application number: 24183091.8
(22) Date of filing: 19.06.2024
(51) Int. Cl.: H01L 23/528, H01L 21/768

(54) **SEMICONDUCTOR DEVICE**

(30) Priority: 30.10.2023 KR 20230147183
(71) Applicant: Samsung Electronics Co., Ltd., Suwon-si, Gyeonggi-do 16677 (KR)
(72) Inventor: SON, Yonghyeok, 16677 Suwon-si (KR); SEO, Jeongil, 16677 Suwon-si (KR); LEE, Donghun, 16677 Suwon-si (KR); KANG, Seungmo, 16677 Suwon-si (KR); LEE, Seung Joo, 16677 Suwon-si (KR); CHO, Yujin, 16677 Suwon-si (KR); CHOI, Seongjun, 16677 Suwon-si (KR)
(74) Representative: Marks & Clerk LLP

(57) **Abstract**

A semiconductor device includes an interconnection line (330), an insulating layer on the interconnection line and having an opening (40) exposing a top surface of the interconnection line (330), and a redistribution pattern (350) extending into the opening and electrically connected to the interconnection line at a bottom surface of the opening. The interconnection line (330) is configured to provide a current path in a first direction (D1) in a region adjacent to the redistribution pattern (350). The opening comprises a first side surface (41) facing the first direction. A corner region (40e1) of the opening (40) protrudes away from or is recessed towards the opening (40) at an end portion of the first side surface (41) of the opening when viewed in plan view.

## Description

### FIELD

The present disclosure relates to a semiconductor device, and more particularly, to a semiconductor device including a redistribution pattern.

### BACKGROUND

Semiconductor devices are widely used in an electronic industry because of their small sizes, multi-functional characteristics, and/or low manufacturing costs. Semiconductor devices may be categorized as semiconductor memory devices for storing logical data, semiconductor logic devices for processing logical data, and hybrid semiconductor devices having functions of both semiconductor memory devices and semiconductor logic devices.

With increased demand for high-speed and/or low-power electronic devices, demand for high-speed and/or low-voltage semiconductor devices used therein has also increased, and highly integrated semiconductor devices have been developed to miniaturize electronic devices. Thus, various techniques for highly integrating semiconductor devices and improving electrical characteristics and reliability of semiconductor devices have been studied.

### SUMMARY

Embodiments of the inventive concepts may provide a semiconductor device with improved electrical characteristics and reliability.

In an aspect, a semiconductor device may include an interconnection line, an insulating layer on the interconnection line and having an opening exposing a top surface of the interconnection line, and a redistribution pattern extending into the opening and electrically connected to the interconnection line at a bottom surface of the opening. The interconnection line may be configured to provide a current path in a first direction in a region adjacent to the redistribution pattern. The opening may have a first side surface facing the first direction. A first corner region of the opening may protrude away from or be recessed toward the opening at a first end portion of the first side surface of the opening when viewed in plan view.

In an aspect, a semiconductor device may include an interconnection line, an insulating layer on the interconnection line and having an opening exposing a top surface of the interconnection line, and a redistribution pattern extending into the opening and electrically connected to the interconnection line at a bottom surface of the opening. The opening may have a first side surface facing a first direction, and a second side surface opposite to the first side surface. A first thickness of a first portion of the redistribution pattern on the first side surface may be greater than a second thickness of a second portion of the redistribution pattern on the second side surface when viewed in plan view.

In an aspect, a semiconductor device may include an interconnection line, an insulating layer on the interconnection line and having an opening exposing a top surface of the interconnection line, and a redistribution pattern extending into the opening and electrically connected to the interconnection line at a bottom surface of the opening. The opening may have a first side surface facing a first direction, and a second side surface opposite to the first side surface. A first portion of the redistribution pattern on the first side surface and a second portion of the redistribution pattern on the second side surface may be asymmetrical about an axis extending in a second direction intersecting the first direction when viewed in plan view.

In an aspect, a semiconductor device may include a semiconductor layer on a substrate, and an interconnection layer on the semiconductor layer. The interconnection layer may include a lower insulating layer and a lower interconnection line in the lower insulating layer, an upper interconnection line on the lower interconnection line, an upper insulating layer on the upper interconnection line and having a first opening exposing a top surface of the upper interconnection line, a redistribution pattern extending into the first opening and electrically connected to the upper interconnection line at a bottom surface of the first opening, and a passivation layer on the redistribution pattern and having a second opening exposing a top surface of the redistribution pattern. The upper interconnection line may be configured to provide a current path in a first direction in a region adjacent to the redistribution pattern. The first opening may have a first side surface facing the first direction. A corner region of the first opening may protrude away from or be recessed towards the first opening at an end portion of the first side surface of the first opening when viewed in a plan view.

At least some of the above and other features of the disclosure are set out in the claims.

### BRIEF DESCRIPTION OF THE DRAWINGS

FIG. 1 is a plan view illustrating a semiconductor device according to some embodiments of the inventive concepts.
FIG. 2 is a cross-sectional view taken along a line A-A' of FIG. 1.
FIG. 3 is a cross-sectional view illustrating a semiconductor layer of FIG. 2 according to some embodiments of the inventive concepts.
FIGS. 4A, 5A, 6, 7, 8, 9, 10, 11, 12, 13, 14A, 15 and 16 are enlarged views corresponding to a portion 'P1' of FIG. 1.
FIGS. 4B, 5B and 14B are enlarged views illustrating first openings of FIGS. 4A, 5A and 14A, respectively.
FIG. 14C is a cross-sectional view taken along a line B-B' of FIG. 14A.
FIG. 17 is a plan view illustrating a semiconductor device according to some embodiments of the inventive concepts.
FIG. 18 is an enlarged view illustrating a portion `P2' of FIG. 17.

### DETAILED DESCRIPTION OF EMBODIMENTS

Example embodiments of the inventive concepts will now be described more fully with reference to the accompanying drawings. The terms "first," "second," etc., may be used herein merely to distinguish one component, layer, direction, etc. from another. The terms "comprises," "comprising," "includes" and/or "including," when used herein, specify the presence of stated elements, but do not preclude the presence of additional elements. The term "and/or" includes any and all combinations of one or more of the associated listed items. The term "connected" may be used herein to refer to a physical and/or electrical connection. When components or layers are referred to herein as "directly" on, or "in direct contact" or "directly connected," no intervening components or layers are present. Likewise, when components are "immediately" adjacent to one another, no intervening components may be present. Similarly, when components or layers are referred to herein as "on" intervening components or layers may be present.

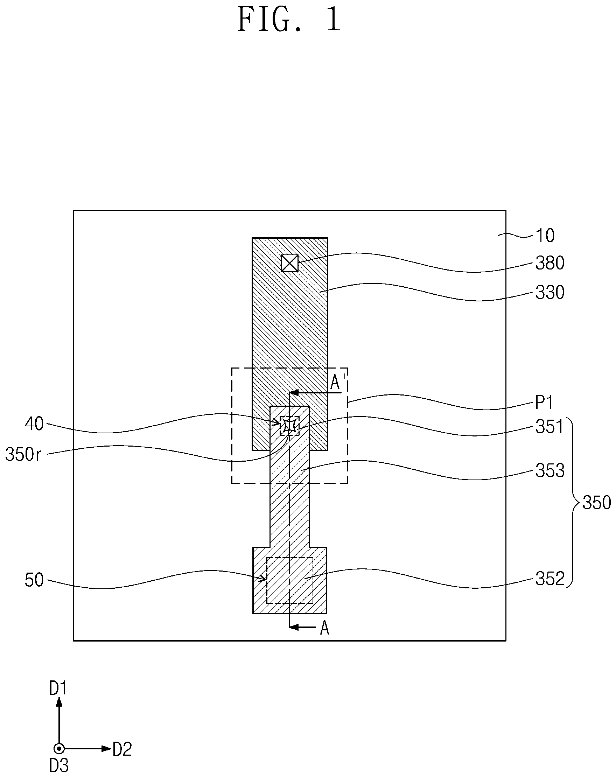

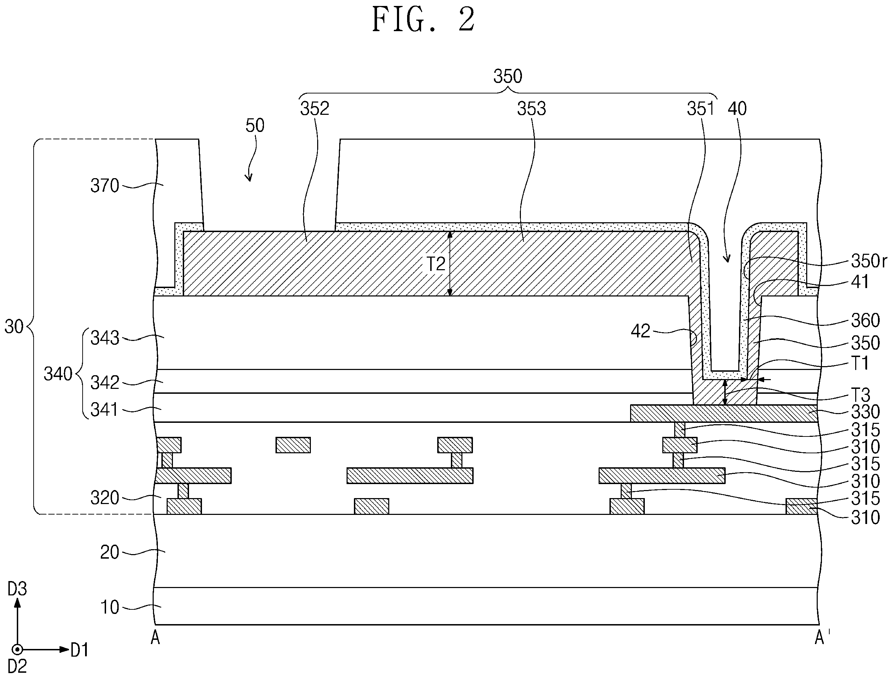

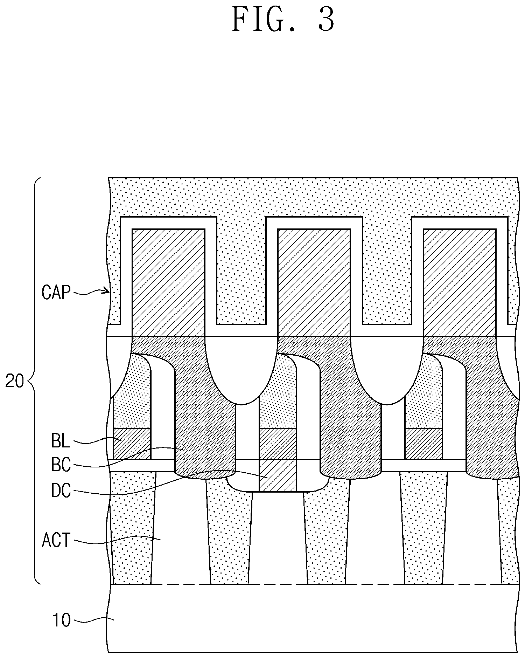

FIG. 1 is a plan view illustrating a semiconductor device according to some embodiments of the inventive concepts. FIG. 2 is a cross-sectional view taken along a line A-A' of FIG. 1. FIG. 3 is a cross-sectional view illustrating a semiconductor layer of FIG. 2 according to some embodiments of the inventive concepts.

Referring to FIGS. 1 to 3, a substrate 10 may be provided. The substrate 10 may be a semiconductor substrate such as a silicon substrate, a germanium substrate, or a silicon-germanium substrate.

A semiconductor layer 20 may be provided on the substrate 10. The semiconductor layer 20 may include one or more field effect transistors (FETs). For example, the field effect transistor may be a metal-oxide-semiconductor FET (MOSFET), but embodiments of the inventive concepts are not limited thereto.

The semiconductor layer 20 may include a semiconductor device such as a semiconductor memory device configured for storing logical data, a semiconductor logic device configured for processing logical data, or a hybrid semiconductor device including a memory element and a logic element. For example, as shown in FIG. 3, the semiconductor layer 20 may include a dynamic random access memory (DRAM) device corresponding to the semiconductor memory device. The DRAM device may include an active pattern ACT, a bit line BL, a bit line node contact DC electrically connecting the bit line BL to the active pattern ACT, a capacitor CAP, a storage node contact BC electrically connecting the capacitor CAP to the active pattern ACT, and a word line (not shown).

An interconnection layer 30 may be provided on the semiconductor layer 20. The interconnection layer 30 may include a lower insulating layer 320, a lower interconnection layer, an upper insulating layer 340, an upper interconnection layer, a redistribution pattern 350, a protective layer 360, and a passivation layer 370.

The lower insulating layer 320 may cover the semiconductor layer 20. The lower insulating layer 320 may include an insulating material. For example, the lower insulating layer 320 may include at least one of silicon oxide, silicon nitride, silicon oxynitride, tetraethylorthosilicate (TEOS), or a low-k dielectric material. In the present specification, the low-k dielectric material may be defined as a material having a dielectric constant lower than that of silicon oxide and may include, for example, SiCOH. For example, the lower insulating layer 320 may be a single layer formed of one of the above materials, or a composite layer formed of two or more of the above materials.

The lower interconnection layer may be provided in the lower insulating layer 320. The lower interconnection layer may include a lower interconnection line 310 and a lower via 315. The lower interconnection line 310 may be electrically connected to the semiconductor layer 20 and/or the upper interconnection layer through the lower via 315. In some embodiments, the lower interconnection line 310 may include a plurality of lower interconnection lines 310 located at different levels (i.e. at different distances relative to the substrate 10), and the lower via 315 may include a plurality of lower vias 315 electrically connecting the plurality of lower interconnection lines 310 to each other. For example, the lower interconnection line 310 and the lower via 315 may include a metal material (e.g., Ti, Mo, W, Co, Cu, Al, Ta, Ru, Ir, etc.).

The upper insulating layer 340 may be provided on the lower insulating layer 320. The upper insulating layer 340 may cover the lower insulating layer 320. The upper insulating layer 340 may include a first upper insulating layer 341, a second upper insulating layer 342 and a third upper insulating layer 343, which are sequentially stacked. The first upper insulating layer 341, the second upper insulating layer 342 and the third upper insulating layer 343 may include different insulating materials. For example, the second upper insulating layer 342 may have an etch selectivity with respect to the first and third upper insulating layers 341 and 343. For example, the first upper insulating layer 341 may be a high-density plasma (HDP) oxide layer, the second upper insulating layer 342 may be a silicon nitride layer, the third upper insulating layer 343 may be a TEOS layer, but embodiments of the inventive concepts are not limited thereto.

The upper interconnection layer may be provided in the upper insulating layer 340. The upper interconnection layer may include an upper interconnection line 330. In the present specification, the upper interconnection line 330 may be defined as an uppermost interconnection line of the interconnection lines 310 and 330. A portion of a top surface of the upper interconnection line 330 may be in contact with the redistribution pattern 350 through a first opening 40 to be described below, and thus the upper interconnection line 330 may be electrically connected to the redistribution pattern 350. Another portion of the top surface of the upper interconnection line 330 may be covered with the upper insulating layer 340 (e.g., the first upper insulating layer 341). For example, the top surface of the upper interconnection line 330 may be located at a lower level (e.g., closer to the substrate 10) than a top surface of the first upper insulating layer 341. For example, the upper interconnection line 330 may include a metal material (e.g., Ti, Mo, W, Co, Cu, Al, Ta, Ru, Ir, etc.).

The upper insulating layer 340 may include a first opening 40. The first opening 40 may penetrate the upper insulating layer 340 provided on the upper interconnection line 330. The first opening 40 may extend from a top surface of the upper insulating layer 340 to the top surface of the upper interconnection line 330. As used herein, "top" surfaces may be surfaces facing away from or opposite to a reference layer or surface (e.g., the substrate 10), while "bottom" surfaces may be surfaces that are facing towards or adjacent the reference layer or surface. The top and bottom surfaces may be (but are not necessarily) the uppermost or lowermost surfaces of a particular element or layer. In some embodiments, the top surface of the upper interconnection line 330 under the first opening 40 may be partially recessed, but embodiments of the inventive concepts are not limited thereto.

The redistribution pattern 350 may be provided on the upper interconnection line 330 and the upper insulating layer 340. The redistribution pattern 350 may cover an inner surface of the first opening 40 and may extend from the inner surface of the first opening 40 to cover the top surface of the upper insulating layer 340. The term "cover" or "surround" or "fill" as may be used herein may not require completely covering or surrounding or filling the described elements or layers, but may, for example, refer to partially covering or surrounding or filling the described elements or layers.

The redistribution pattern 350 may include a first portion 351, a second portion 352, and a third portion 353. The first portion 351 of the redistribution pattern 350 may be a portion of the redistribution pattern 350, which is provided in a region vertically overlapping with the first opening 40. The second portion 352 of the redistribution pattern 350 may be another portion of the redistribution pattern 350, which is provided in a region vertically overlapping with a second opening 50 to be described below. The third portion 353 of the redistribution pattern 350 may be still another portion of the redistribution pattern 350 provided in a region not vertically overlapping with the first and second openings 40 and 50. Components or layers described with reference to "overlap" in a particular direction may be at least partially obstructed by one another when viewed along a line extending in the particular direction or in a plane perpendicular to the particular direction.

The first portion 351 of the redistribution pattern 350 may be provided on the inner surface of the first opening 40. Since the first portion 351 is provided along the inner surface of the first opening 40, the redistribution pattern 350 may have a recess 350r provided on a bottom surface of the first opening 40. The recess 350r of the redistribution pattern 350 may be surrounded by the first opening 40 when viewed in a plan view. The recess 350r may have a symmetrical or asymmetrical shape with respect to a line which passes through a center of the recess 350r and is perpendicular to a first direction D1, when viewed in a plan view.

The first portion 351 may be in contact with the top surface of the upper interconnection line 330 at the bottom surface of the first opening 40, and thus the redistribution pattern 350 may be electrically connected to the upper interconnection line 330. Therefore, the upper interconnection line 330 may have a current path. In the present specification, the current path of the upper interconnection line 330 may be defined as a path in the upper interconnection line 330, in which a current flows when the current flows between the upper interconnection line 330 and the redistribution pattern 350.

The upper interconnection line 330 may have the current path in a direction parallel to a bottom surface of the substrate 10 in a region adjacent to the redistribution pattern 350, and the parallel direction may be defined as the first direction D1. In some embodiments, a conductive contact 380 may be electrically connected to the upper interconnection line 330, and the upper interconnection line 330 may electrically connect the conductive contact 380 to the redistribution pattern 350. Here, as shown in FIG. 1, the conductive contact 380 may be spaced apart from the redistribution pattern 350 in the first direction D1, and the upper interconnection line 330 may extend in the first direction D1. Thus, the upper interconnection line 330 may have the current path in the first direction D1 in the region adjacent to the redistribution pattern 350. In certain embodiments, the conductive contact 380 may be shifted from the redistribution pattern 350 in a second direction D2 which is parallel to the bottom surface of the substrate 10 and intersects the first direction D1, but the upper interconnection line 330 may extend in the first direction D1 in the region adjacent to the redistribution pattern 350 to have the current path in the first direction D1. In some embodiments, the conductive contact 380 may be the lower via 315 or another redistribution pattern, but embodiments of the inventive concepts are not limited thereto.

The second portion 352 of the redistribution pattern 350 may be located under the second opening 50 to be described below in detail and may be exposed to the outside at a bottom surface of the second opening 50. The third portion 353 of the redistribution pattern 350 may connect the first portion 351 to the second portion 352. In some embodiments, the third portion 353 may extend in a direction parallel to the current path (i.e., the first direction D1), but embodiments of the inventive concepts are not limited thereto.

In some embodiments, the redistribution pattern 350 may be formed using a physical vapor deposition (PVD) process having poor step coverage characteristics, and thus the redistribution pattern 350 may include portions having different thicknesses.

A thickness of the first portion 351 in a horizontal direction (e.g., the first direction D1) on a side surface of the first opening 40 may be changed depending on a level when viewed in a cross-sectional view. For example, a minimum thickness T1 of the first portion 351 in the horizontal direction on the side surface of the first opening 40 may range from 0.1µm to 0.5µm. If the minimum thickness T1 is less than 0.1 µm, a current density in the first portion 351 of the redistribution pattern 350 may be too high, which may deteriorate electrical characteristics and reliability of a semiconductor device. If the minimum thickness T1 is greater than 0.5µm, a thickness of another portion of the redistribution pattern 350 may be too large, such that it may be difficult to form a fine pattern of a semiconductor device.

A thickness T2, in a third direction D3 (which is perpendicular to the bottom surface of the substrate 10) of the redistribution pattern 350 on the top surface of the upper insulating layer 340 may be greater than a thickness T3 (in the third direction D3) of the redistribution pattern 350 on the top surface of the upper interconnection line 330 when viewed in a cross-sectional view. For example, the thickness T3 of the redistribution pattern 350 on the top surface of the upper interconnection line 330 may range from 50% to 95% of the thickness T2 of the redistribution pattern 350 on the top surface of the upper insulating layer 340.

The protective layer 360 may cover the redistribution pattern 350 and the upper insulating layer 340. The protective layer 360 may cover the redistribution pattern 350 and the upper insulating layer 340 with a substantially uniform thickness. For example, the protective layer 360 may include at least one of silicon nitride or silicon oxynitride.

The passivation layer 370 may cover the protective layer 360. For example, the passivation layer 370 may be formed using a spin coating process. For example, the passivation layer 370 may include a polyimide-based material such as photosensitive polyimide (PSPI).

The passivation layer 370 may include the second opening 50. The second opening 50 may be formed on the redistribution pattern 350 and may define the third portion 353 of the redistribution pattern 350. The second opening 50 may penetrate the passivation layer 370 and the protective layer 360 on the redistribution pattern 350. The second opening 50 may extend from a top surface of the passivation layer 370 to a top surface of the redistribution pattern 350. In some embodiments, the top surface of the redistribution pattern 350 under the second opening 50 may be partially recessed, but embodiments of the inventive concepts are not limited thereto. The second portion 352 of the redistribution pattern 350 may be exposed to the outside through the second opening 50. The redistribution pattern 350 may be electrically connected to an external device through the exposed second portion 352. The term "exposed," may be used to describe relationships between elements (e.g., in fabricating a completed semiconductor device), but may not necessarily require exposure of the particular region, layer, structure or other element in the context of the completed device.

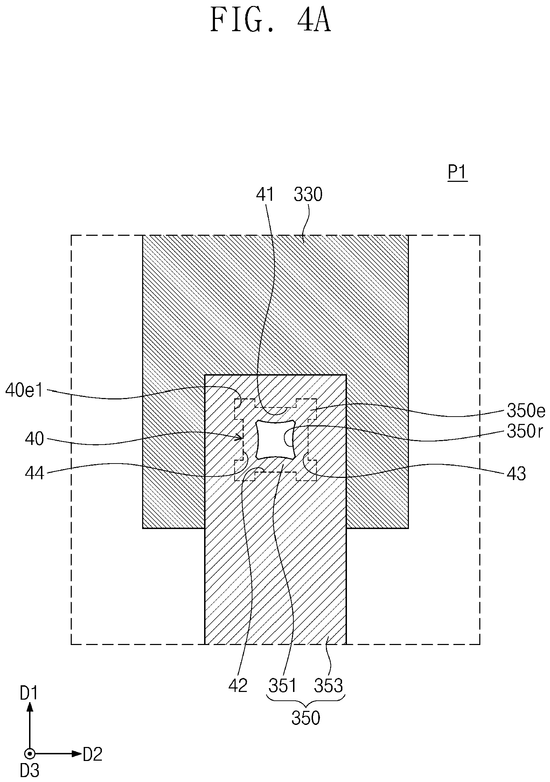

Hereinafter, various shapes of the first opening 40 according to some embodiments of the inventive concepts will be described in more detail with reference to FIGS. 4A to 16.

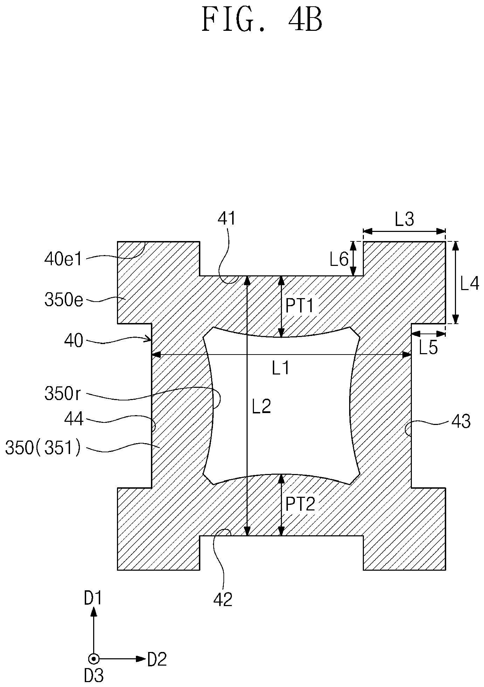

FIG. 4A is an enlarged view corresponding to a portion `P1' of FIG. 1. FIG. 4B is an enlarged view illustrating a first opening of FIG. 4A.

Referring to FIGS. 4A and 4B, the first opening 40 may have first to fourth side surfaces 41, 42, 43 and 44. The first side surface 41 may face the first direction D1, and the second side surface 42 may be opposite to the first side surface 41. The third side surface 43 may face the second direction D2, and the fourth side surface 44 may be opposite to the third side surface 43. A width of the first opening 40 in the second direction D2 may be defined as a distance between the third side surface 43 and the fourth side surface 44 and may be defined as a first length L1. A width of the first opening 40 in the first direction D1 may be defined as a distance between the first side surface 41 and the second side surface 42 and may be defined as a second length L2. The first length L1 and the second length L2 may be equal to each other or may be different from each other.

The first opening 40 may have a corner region 40e1. The corner region 40e1 may be provided in plurality. For example, four corner regions 40e1 may be provided between the first side surface 41 and the third side surface 43, between the first side surface 41 and the fourth side surface 44, between the second side surface 42 and the third side surface 43, and between the second side surface 42 and the fourth side surface 44, respectively.

The four corner regions 40e1 may protrude from the first to fourth side surfaces 41, 42, 43 and 44 toward the outside of (i.e., away from) the first opening 40. For example, the corner region 40e1 between the first and third side surfaces 41 and 43 may protrude from the first side surface 41 in the first direction D1 and may protrude from the third side surface 43 in the second direction D2.

Since the four corner regions 40e1 are disposed at all corners of the first opening 40, the first opening 40 may have a symmetrical shape with respect to the first direction D1 and the second direction D2 when viewed in a plan view. For example, the first side surface 41 and the second side surface 42 may have substantially the same length and thus may be symmetrical with respect to a line extending in the second direction D2. For example, the third side surface 43 and the fourth side surface 44 may have substantially the same length and thus may be symmetrical with respect to a line extending in the first direction D 1.

The first portion 351 of the redistribution pattern 350 may be provided on the first opening 40. The first portion 351 may cover the first to fourth side surfaces 41, 42, 43 and 44 and the corner regions 40e1 of the first opening 40 and may have the recess 350r surrounded by them 41 to 44 and 40e1. The redistribution pattern 350 may have a corner pattern 350e filling the corner region 40e1 of the first opening 40.

The redistribution pattern 350 may have a non-uniform thickness on the side surfaces 41, 42, 43 and 44 of the first opening 40 in a plan view due to the characteristics of the PVD process when the redistribution pattern 350 is formed. For example, a thickness PT1 of the redistribution pattern 350 on the first side surface 41 may be substantially equal to a thickness PT2 of the redistribution pattern 350 on the second side surface 42. For example, the redistribution pattern 350 may have a maximum thickness in a region adjacent to a central portion of each of the side surfaces 41, 42, 43 and 44 of the first opening 40, and each of the thicknesses PT1 and PT2 may mean or may refer to the maximum thickness of the redistribution pattern 350 on each of the first and second side surfaces 41 and 42.

If the corner region 40e1 is not provided, a thickness of the redistribution pattern 350 may be relatively thin at a corner at which side surfaces of the first opening 40 meet each other, and thus a current density in the redistribution pattern 350 may be too high. This may deteriorate electrical characteristics and reliability of a semiconductor device. According to the inventive concepts, the first opening 40 may include the corner region 40e1 and the redistribution pattern 350 may have the corner pattern 350e, and thus the redistribution pattern 350 may have a sufficient thickness in a region adjacent to the corner region 40e1. As used herein, a sufficient thickness may refer to a thickness that is configured to reduce or prevent concentration of current density relative to at least one other portion of the redistribution pattern 350. As a result, concentration of the current density in a specific region in the redistribution pattern 350 may be reduced or minimized to improve the electrical characteristics and reliability of the semiconductor device.

A width of the corner region 40e1 in the second direction D2 may be defined as a third length L3, and a width of the corner region 40e1 in the first direction D1 may be defined as a fourth length L4. The third length L3 may range from 1% to 40% of the first length L1, and the fourth length L4 may range from 1% to 40% of the second length L2. If each of the third and fourth lengths L3 and L4 has a value less than the corresponding numerical range, thickness reinforcement of the redistribution pattern 350 may not be effectively achieved. If each of the third and fourth lengths L3 and L4 has a value greater than the corresponding numerical range, the corner region 40e1 may be excessively greater than the side surfaces 41, 42, 43 and 44. Thus, a corner of the first opening 40 may have a substantially similar structure to that of an opening at which the corner region 40e1 is not provided, and the thickness reinforcement of the redistribution pattern 350 may not be effectively achieved.

The corner region 40e1 may protrude by a fifth length L5 in the second direction D2 or an opposite direction thereto and may protrude by a sixth length L6 in the first direction D1 or an opposite direction thereto. The fifth length L5 may range from 20% to 70% of the third length L3, and the sixth length L6 may range from 20% to 70% of the fourth length L4. If the fifth length L5 or the sixth length L6 has a value that is less than or greater than the corresponding numerical range, the thickness reinforcement of the redistribution pattern 350 may not be effectively achieved by reasons similar to those described for the third length L3 and the fourth length L4. As such, in some embodiments, one or more of the widths or lengths L3, L4, L5, L6 may be critical to achieving the thickness reinforcement (and associated effects on current density and reliability) as described herein.

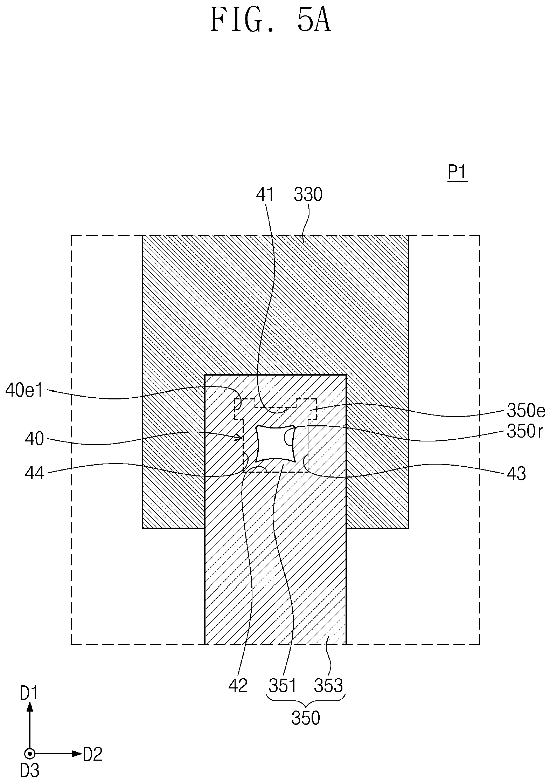

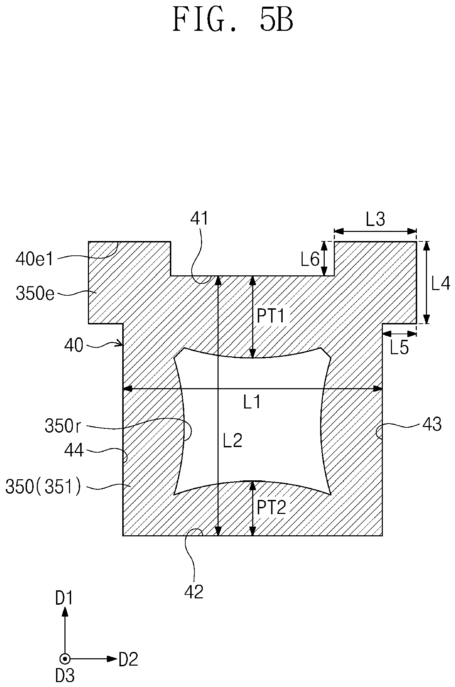

FIG. 5A is an enlarged view corresponding to the portion 'P1' of FIG. 1. FIG. 5B is an enlarged view illustrating a first opening of FIG. 5A.

Referring to FIGS. 5A and 5B, a first opening 40 may have an asymmetrical shape about an axis or with respect to a line extending in the second direction D2. For example, a pair of the corner regions 40e1 may be provided at both end portions of the first side surface 41, respectively, and the corner region 40e1 may not be provided in a region adjacent to the second side surface 42. Thus, the first side surface 41 and the second side surface 42 may have different lengths and may be asymmetrical. Both end portions of the second side surface 42 may meet the third side surface 43 and the fourth side surface 44, respectively.

Since the corner region 40e1 is provided at the first side surface 41 but is not provided at the second side surface 42, thicknesses of the redistribution pattern 350 on the first side surface 41 and the second side surface 42 may be different from each other. For example, the pair of corner regions 40e1 may be provided at both end portions of the first side surface 41, and thus a thickness PT1 of the redistribution pattern 350 on the first side surface 41 may be greater than a thickness PT2 of the redistribution pattern 350 on the second side surface 42. Thus, the redistribution pattern 350 and the recess 350r thereof may also have asymmetrical shapes about an axis or with respect to a line extending in the second direction D2.

Since the upper interconnection line 330 has the current path in the first direction D1, a current density in the redistribution pattern 350 on the first side surface 41 may be relatively high. Thus, the first opening 40 may have only the corner region 40e1 adjacent to the first side surface 41.

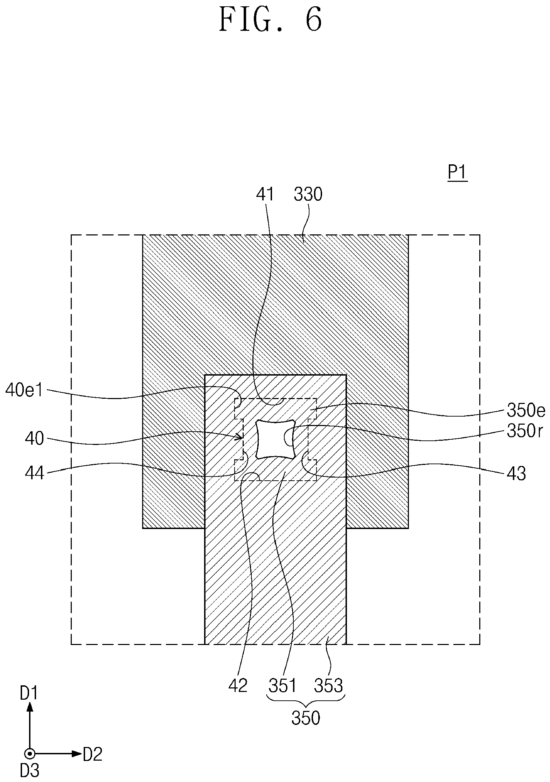

FIG. 6 is an enlarged view corresponding to the portion 'P1' of FIG. 1.

Referring to FIG. 6, a corner region 40e1 may protrude in the second direction D2 or the opposite direction thereto but may not protrude in the first direction D1 or the opposite direction thereto. Since the corner region 40e1 protrudes in the second direction D2 or the opposite direction thereto, thicknesses of the redistribution pattern 350 on the first side surface 41 and the second side surface 42 may be reinforced.

The first opening 40 may have four corner regions 40e1. Since the four corner regions 40e1 are disposed at all corners of the first opening 40, the first opening 40 may have a symmetrical shape with respect to the first direction D1 and the second direction D2 when viewed in a plan view. For example, the first side surface 41 and the second side surface 42 may have substantially the same length and thus may be symmetrical about an axis or with respect to a line extending in the second direction D2. For example, the third side surface 43 and the fourth side surface 44 may have substantially the same length and thus may be symmetrical about an axis or with respect to a line extending in the first direction D1. Since the first opening 40 has the symmetrical shape, each of the redistribution pattern 350 and the recess 350r thereof may also have a symmetrical shape.

However, in contrast to FIG. 6, the corner region 40e1 may protrude in the first direction D1 or the opposite direction thereto but may not protrude in the second direction D2 or the opposite direction thereto. More generally, embodiments described herein may include similar protrusion configurations (but in different directions) than those specifically illustrated in the drawings.

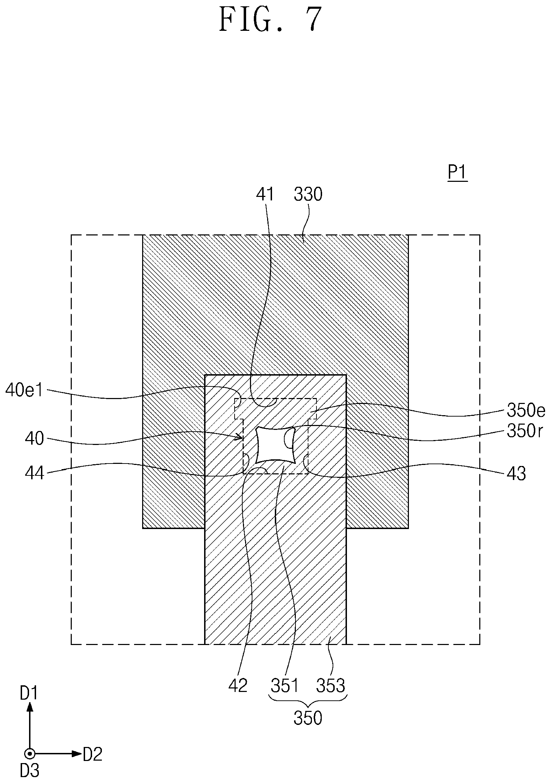

FIG. 7 is an enlarged view corresponding to the portion 'P1' of FIG. 1.

Referring to FIG. 7, a first opening 40 may have an asymmetrical shape about an axis or with respect to a line extending in the second direction D2. For example, a pair of the corner regions 40e1 may be provided at both end portions of the first side surface 41, respectively, and the corner region 40e1 may not be provided in a region adjacent to the second side surface 42. Thus, the first side surface 41 and the second side surface 42 may have different lengths and may be asymmetrical.

Thicknesses of the redistribution pattern 350 on the first side surface 41 and the second side surface 42 may be different from each other due to the asymmetrical arrangement of the corner region 40e1. Thus, the redistribution pattern 350 and the recess 350r thereof may also have asymmetrical shapes about an axis or with respect to a line extending in the second direction D2.

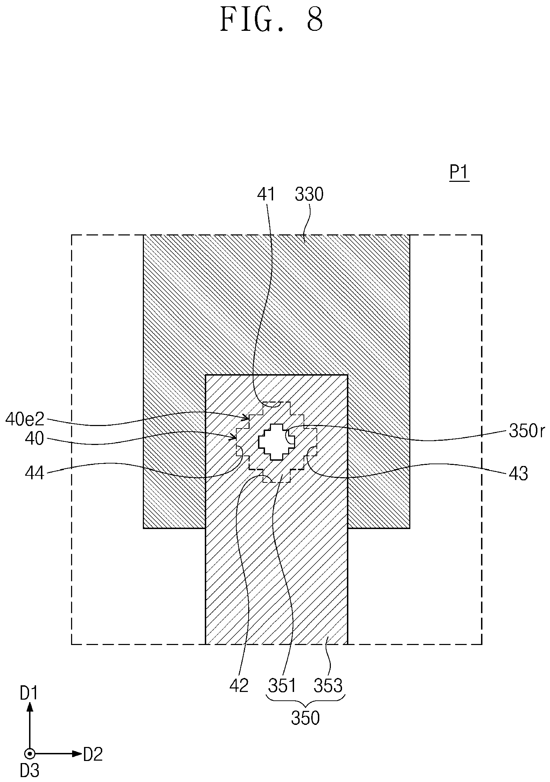

FIG. 8 is an enlarged view corresponding to the portion 'P1' of FIG. 1.

Referring to FIG. 8, a first opening 40 may have a corner region 40e2 recessed from a side surface adjacent thereto into the first opening 40. For example, four corner regions 40e2 may be provided between the first side surface 41 and the third side surface 43, between the first side surface 41 and the fourth side surface 44, between the second side surface 42 and the third side surface 43, and between the second side surface 42 and the fourth side surface 44, respectively.

Since the four corner regions 40e2 are disposed at all corners of the first opening 40, the first opening 40 may have a symmetrical shape with respect to the first direction D1 and the second direction D2 when viewed in a plan view. For example, the first side surface 41 and the second side surface 42 may have substantially the same length and thus may be symmetrical about an axis or with respect to a line extending in the second direction D2. For example, the third side surface 43 and the fourth side surface 44 may have substantially the same length and thus may be symmetrical about an axis or with respect to a line extending in the first direction D1. Since the first opening 40 has the symmetrical shape, each of the redistribution pattern 350 and the recess 350r thereof may also have a symmetrical shape.

The corner region 40e2 may have a stepped shape. For example, the corner region 40e2 may have the stepped shape and may connect two side surfaces adjacent to each other. The corner region 40e2 may include one or more stepped shapes.

When the redistribution pattern 350 is formed, a size of an angled portion of the redistribution pattern 350 in the first opening 40 may be reduced due to the corner region 40e2 recessed into the first opening 40. Thus, the redistribution pattern 350 may be formed to have a relatively uniform thickness, and it is possible to prevent or avoid a phenomenon that a current density is too high in a specific region due to a thin thickness. As a result, concentration of the current density in a specific region in the redistribution pattern 350 may be reduced or minimized to improve electrical characteristics and reliability of the semiconductor device.

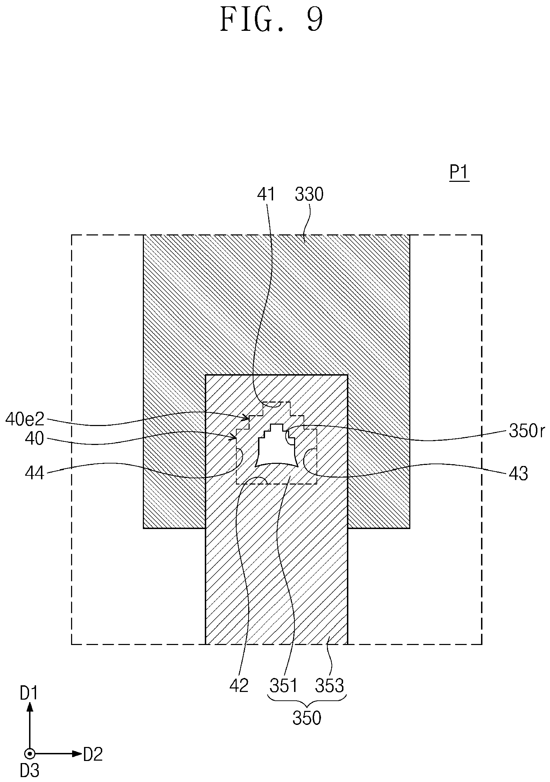

FIG. 9 is an enlarged view corresponding to the portion 'P1' of FIG. 1.

Referring to FIG. 9, a first opening 40 may have an asymmetrical shape about an axis or with respect to a line extending in the second direction D2. For example, a pair of the corner regions 40e2 having the stepped shapes may be provided at both end portions of the first side surface 41, respectively, but the corner region 40e2 may not be provided in a region adjacent to the second side surface 42. Thus, the first side surface 41 and the second side surface 42 may have different lengths and may be asymmetrical.

The redistribution pattern 350 and the recess 350r thereof may also have asymmetrical shapes about an axis or with respect to a line extending in the second direction D2 due to the asymmetrical arrangement of the corner region 40e2. The redistribution pattern 350 on the first side surface 41 may have a more uniform thickness than the redistribution pattern 350 on the second side surface 42.

Since the upper interconnection line 330 has the current path in the first direction D1, a current density in the redistribution pattern 350 on the first side surface 41 may be relatively high. Thus, the first opening 40 may have only the corner region 40e2 adjacent to the first side surface 41.

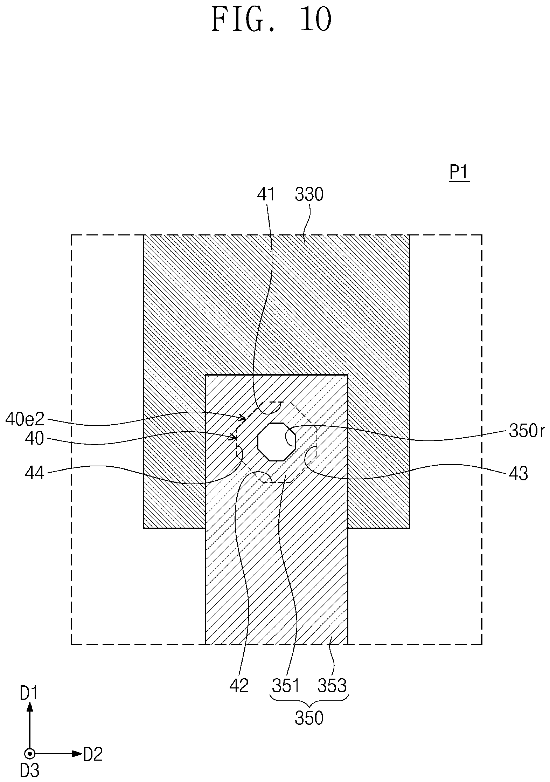

FIG. 10 is an enlarged view corresponding to the portion 'P1' of FIG. 1.

Referring to FIG. 10, a first opening 40 may have a corner region 40e2 recessed from a side surface adjacent thereto into the first opening 40, and the corner region 40e2 may extend in a straight line shape, also referred to as a chamfered edge or corner. The corner region 40e2 may extend in a direction intersecting the first and second directions D1 and D2.

For example, four corner regions 40e2 may extend in the straight line shape between the first side surface 41 and the third side surface 43, between the first side surface 41 and the fourth side surface 44, between the second side surface 42 and the third side surface 43, and between the second side surface 42 and the fourth side surface 44, respectively. Here, each of the four corner regions 40e2 may form an obtuse angle with each of two side surfaces adjacent thereto and may connect the two side surfaces to provide chamfered edges. For example, the corner region 40e2 between the first side surface 41 and the third side surface 43 may form the obtuse angle with each of the first and third side surfaces 41 and 43 and may connect the first and third side surfaces 41 and 43.

Since the four corner regions 40e2 are disposed at all corners of the first opening 40, the first opening 40 may have a symmetrical shape with respect to the first direction D1 and the second direction D2 when viewed in a plan view. For example, the first opening 40 may have a polygonal shape (e.g., an octagonal shape). Since the first opening 40 has the symmetrical shape, each of the redistribution pattern 350 and the recess 350r thereof may also have a symmetrical shape.

When the redistribution pattern 350 is formed, the redistribution pattern 350 may be formed to have a relatively uniform thickness, due to the corner region 40e2 recessed into the first opening 40 and forming the obtuse angle with the side surfaces adjacent thereto. Thus, it is possible to prevent or avoid a current density from being excessively increased by a thin thickness in a specific region in the redistribution pattern 350. As a result, concentration of the current density in a specific region in the redistribution pattern 350 may be reduced or minimized to improve electrical characteristics and reliability of the semiconductor device.

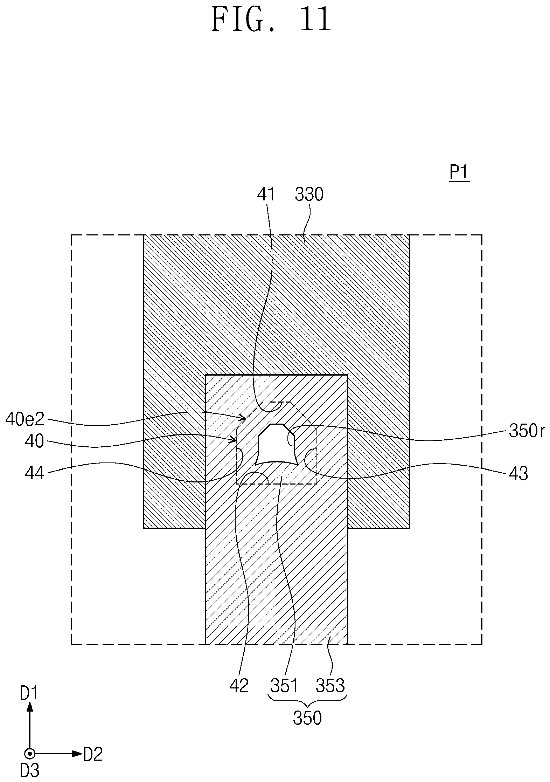

FIG. 11 is an enlarged view corresponding to the portion 'P1' of FIG. 1.

Referring to FIG. 11, a first opening 40 may have an asymmetrical shape about an axis or with respect to a line extending in the second direction D2. For example, a pair of the corner regions 40e2 having the straight line shapes (i.e., a pair of chamfered edges) may be provided at both end portions of the first side surface 41, respectively, but the corner region 40e2 may not be provided in a region adjacent to the second side surface 42. Thus, the first side surface 41 and the second side surface 42 may have different lengths and may be asymmetrical.

The redistribution pattern 350 and the recess 350r thereof may also have asymmetrical shapes about an axis or with respect to a line extending in the second direction D2 due to the asymmetrical arrangement of the corner region 40e2. The redistribution pattern 350 on the first side surface 41 may have a more uniform thickness than the redistribution pattern 350 on the second side surface 42.

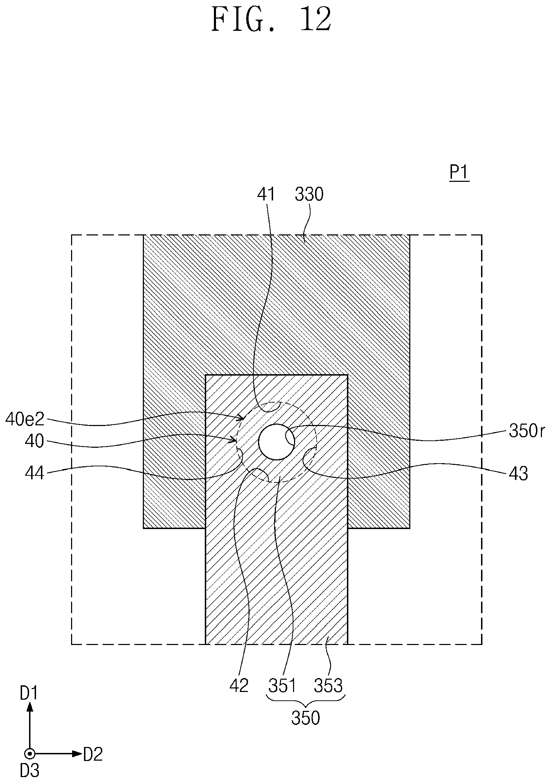

FIG. 12 is an enlarged view corresponding to the portion 'P1' of FIG. 1.

Referring to FIG. 12, a first opening 40 may have a corner region 40e2 which is recessed from the side surface adjacent thereto into the first opening 40 and has a curved surface convex toward the outside of or facing away from the first opening 40. For example, four corner regions 40e2 may have the convex curved surfaces between the first side surface 41 and the third side surface 43, between the first side surface 41 and the fourth side surface 44, between the second side surface 42 and the third side surface 43, and between the second side surface 42 and the fourth side surface 44, respectively.

In a case in which a size of the corner region 40e2 is increased, as shown in FIG. 12, the first opening 40 may have a substantially circular shape when viewed in a plan view. Thus, each of the first to fourth side surfaces 41, 42, 43 and 44 may be a portion of the curved surface forming the first opening 40.

Since the four corner regions 40e2 are disposed at all corners of the first opening 40, the first opening 40 may have a symmetrical shape with respect to the first direction D1 and the second direction D2 when viewed in a plan view. Since the first opening 40 has the symmetrical shape, each of the redistribution pattern 350 and the recess 350r thereof may also have a symmetrical shape.

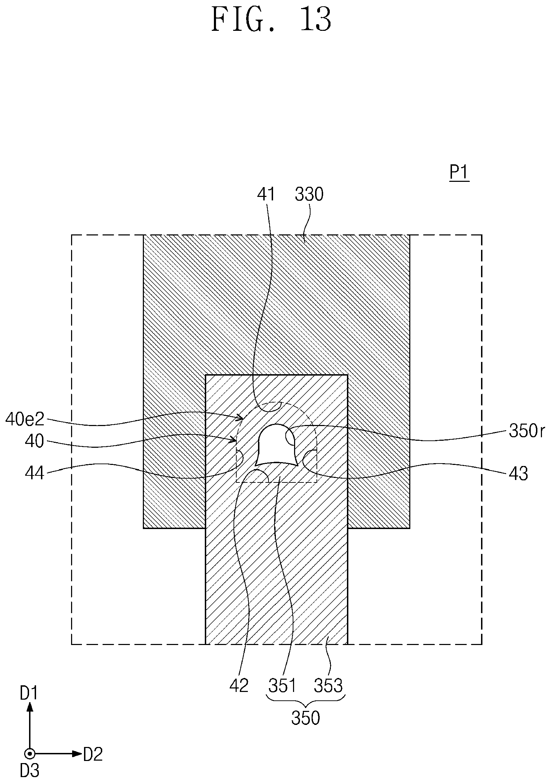

FIG. 13 is an enlarged view corresponding to the portion 'P1' of FIG. 1.

Referring to FIG. 13, a first opening 40 may have an asymmetrical shape about an axis or with respect to a line extending in the second direction D2. For example, a pair of the corner regions 40e2 having the convex curved surfaces may be provided at both end portions of the first side surface 41, respectively, but the corner region 40e2 may not be provided in a region adjacent to the second side surface 42. Thus, the first side surface 41 and the second side surface 42 may have different lengths and may be asymmetrical. For example, the first side surface 41 may be a portion of the curved surface, and the second side surface 42 may have a straight line shape extending in the second direction D2.

The redistribution pattern 350 and the recess 350r thereof may also have asymmetrical shapes about an axis or with respect to a line extending in the second direction D2 due to the asymmetrical arrangement of the corner region 40e2. The redistribution pattern 350 on the first side surface 41 may have a more uniform thickness than the redistribution pattern 350 on the second side surface 42.

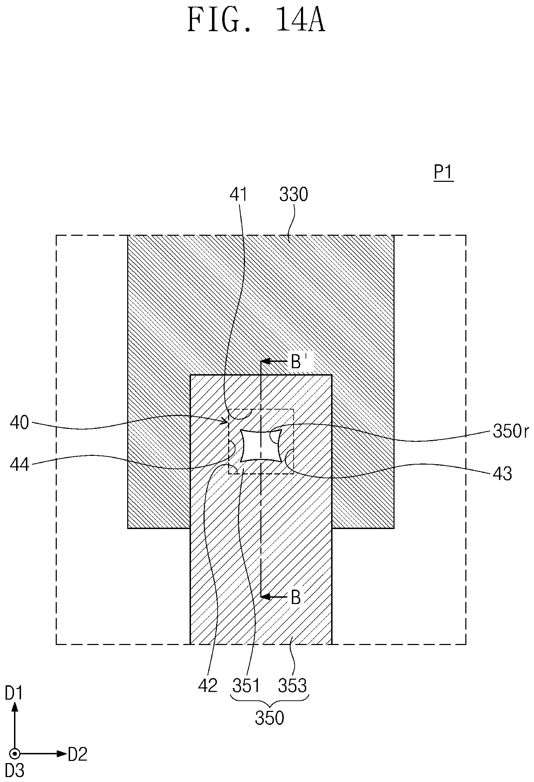

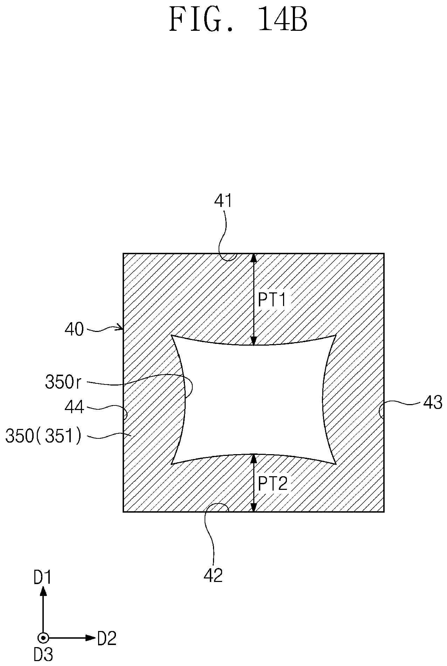

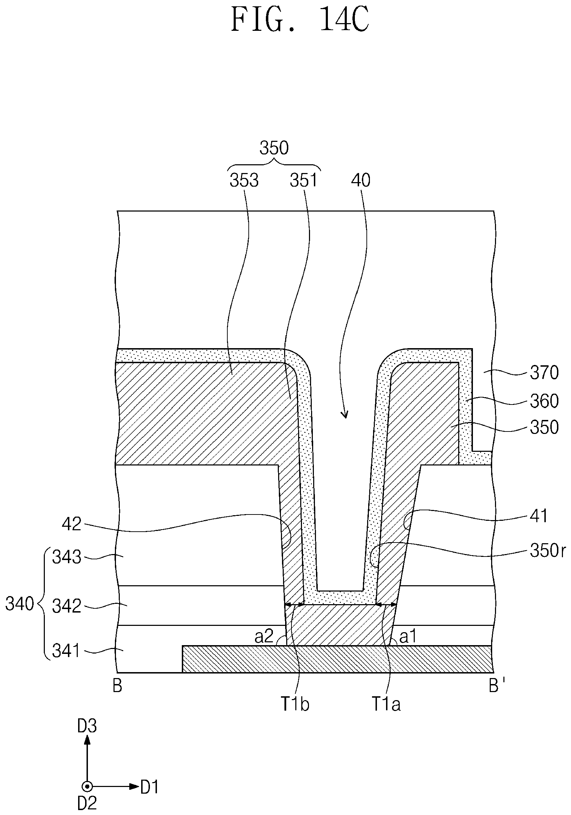

FIG. 14A is an enlarged view corresponding to the portion 'P1' of FIG. 1. FIG. 14B is an enlarged view illustrating a first opening of FIG. 14A. FIG. 14C is a cross-sectional view taken along a line B-B' of FIG. 14A.

Referring to FIGS. 14A to 14C, a gradient or angle of inclination of the first side surface 41 may be different from a gradient of the second side surface 42 when viewed in a cross-sectional view. More particularly, the first side surface 41 may form a first angle a1 with the top surface of the upper interconnection line 330, and the second side surface 42 may form a second angle a2 with the top surface of the upper interconnection line 330. The first angle a1 may be less than the second angle a2.

Since the first angle a1 and the second angle a2 have different values, a thickness of the redistribution pattern 350 on the first side surface 41 may be different from a thickness of the redistribution pattern 350 on the second side surface 42. For example, a thickness PT1 of the redistribution pattern 350 on the first side surface 41 may be greater than a thickness PT2 of the redistribution pattern 350 on the second side surface 42 when viewed in a plan view. For example, a minimum thickness T1a of the redistribution pattern 350 on the first side surface 41 may be greater than a minimum thickness T1b of the redistribution pattern 350 on the second side surface 42 when viewed in a cross-sectional view.

Since the thicknesses of the redistribution pattern 350 on the first and second side surfaces 41 and 42 are different from each other, the redistribution pattern 350 and the recess 350r thereof may have asymmetrical shapes about an axis or with respect to a line extending in the second direction D2. For example, the redistribution pattern 350 on the first side surface 41 and the redistribution pattern 350 on the second side surface 42 may be asymmetrical.

Since the upper interconnection line 330 has the current path in the first direction D1, a current density in the redistribution pattern 350 on the first side surface 41 may be relatively high. Thus, the first side surface 41 may be relatively more inclined, and thus the thickness of the redistribution pattern 350 on the first side surface 41 may be reinforced. Even though not shown in the drawings, the first opening 40 may further include at least one of the aforementioned corner regions 40e1 and 40e2.

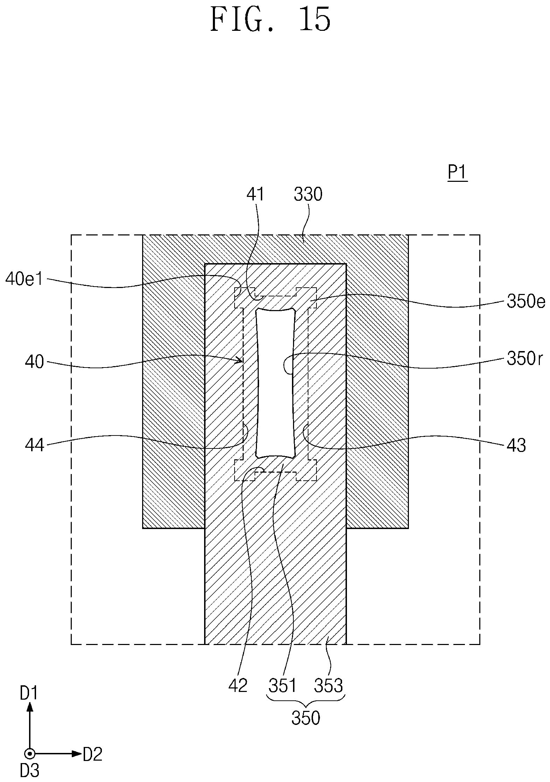

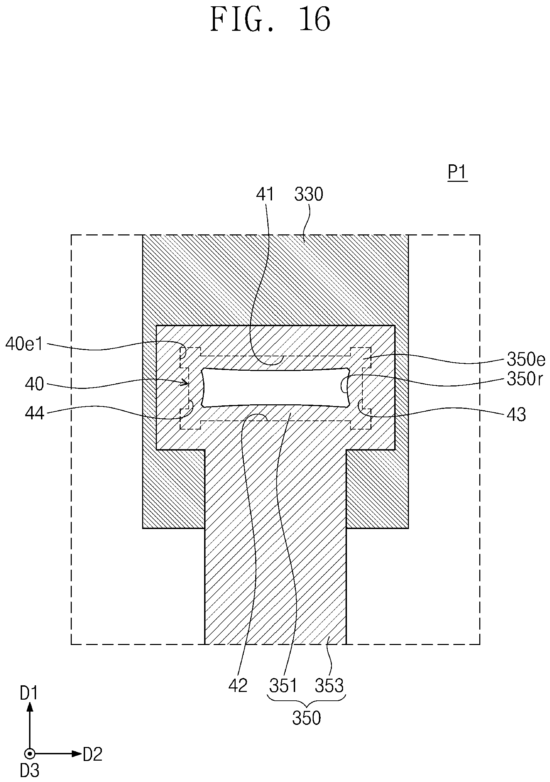

FIG. 15 is an enlarged view corresponding to the portion 'P1' of FIG. 1. FIG. 16 is an enlarged view corresponding to the portion 'P1' of FIG. 1.

Referring to FIGS. 15 and 16, a first opening 40 may have a bar shape longitudinally extending in the first direction D1 or the second direction D2. The first opening 40 having the bar shape may have at least one of the various corner regions 40e1 and 40e2 according to the aforementioned embodiments. For example, as shown in FIGS. 15 and 16, the first opening 40 may have the four protruding corner regions 40e1. Even though not shown in the drawings, the first side surface 41 and the second side surface 42 may have different gradients, like FIGS. 14A to 14C.

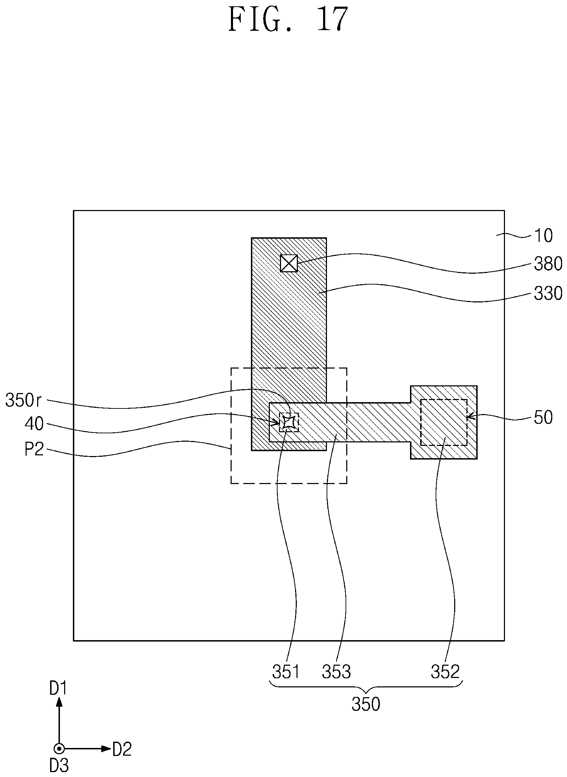

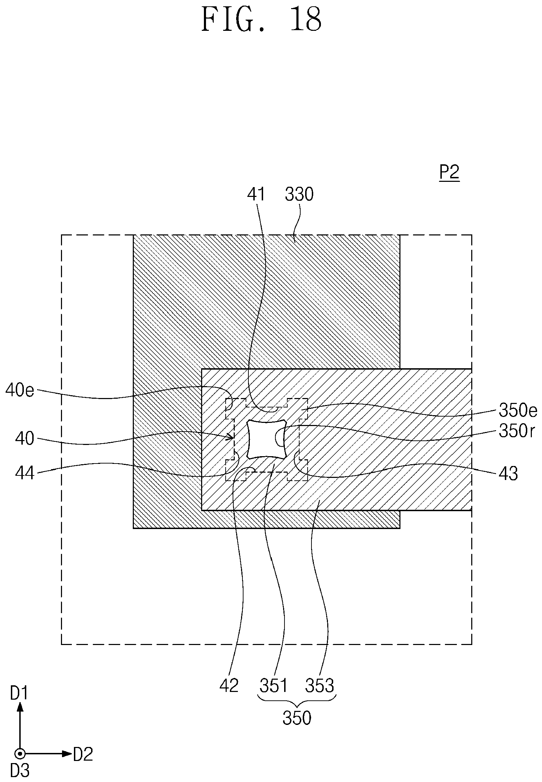

FIG. 17 is a plan view illustrating a semiconductor device according to some embodiments of the inventive concepts. FIG. 18 is an enlarged view illustrating a portion `P2' of FIG. 17.

Referring to FIGS. 17 and 18, the upper interconnection line 330 may have the current path in the first direction D1 in a region adjacent to the redistribution pattern 350. Here, unlike FIG. 1, a third portion 353 of a redistribution pattern 350 may extend in a direction (e.g., the second direction D2) intersecting the current path.

The first opening 40 may have at least one of the various corner regions 40e1 and 40e2 according to the aforementioned embodiments. For example, as shown in FIG. 18, the first opening 40 may have the four protruding corner regions 40e1. Even though not shown in the drawings, the first side surface 41 and the second side surface 42 may have different gradients, like FIGS. 14A to 14C.

According to the inventive concepts, the redistribution pattern may be provided to have a sufficient thickness along the current path of the upper interconnection line. As a result, concentration of the current density in a specific region in the redistribution pattern by the current path may be reduced or minimized, and thus the electrical characteristics and reliability of the semiconductor device may be improved.

While the embodiments of the inventive concepts have been particularly shown and described, it will be understood by one of ordinary skill in the art that variations in form and detail may be made therein without departing from the scope of the attached claims.

Embodiments are set out in the following clauses:
Clause 1: A semiconductor device comprising:
   an interconnection line;
   an insulating layer on the interconnection line and having an opening exposing a top surface of the interconnection line; and
   a redistribution pattern extending into the opening and electrically connected to the interconnection line at a bottom surface of the opening,
   wherein the interconnection line is configured to provide a current path in a first direction in a region adjacent to the redistribution pattern,
   wherein the opening comprises a first side surface facing the first direction, and
   wherein a first corner region of the opening protrudes away from or is recessed toward the opening at a first end portion of the first side surface of the opening when viewed in plan view.
Clause 2: The semiconductor device of clause 1, wherein a second corner region of the opening protrudes away from or is recessed toward the opening at a second end portion of the first side surface of the opening when viewed in plan view.
Clause 3: The semiconductor device of clause 1 or 2, wherein the opening further comprises a second side surface opposite to the first side surface, and
   wherein the first side surface and the second side surface are symmetrical about an axis extending in the first direction.
Clause 4: The semiconductor device of clause 3, wherein a corner region of the opening protrudes away from or is recessed toward the opening at an end portion of the second side surface of the opening when viewed in plan view.
Clause 5: The semiconductor device of clause 1 or 2, wherein the opening further comprises a second side surface opposite to the first side surface, and
   wherein the first side surface and the second side surface are asymmetrical about an axis extending in a second direction intersecting the first direction.
Clause 6: The semiconductor device of clause 5, wherein a corner region of the opening does not protrude away from or is not recessed toward the opening at an end portion of the second side surface of the opening when viewed in plan view.
Clause 7: The semiconductor device of any preceding clause, wherein the opening further comprises a second side surface opposite to the first side surface,
   wherein the first corner region protrudes in a second direction intersecting the first direction, and
   wherein a width of the first corner region in the first direction ranges from about 1% to about 40% of a distance between the first side surface and the second side surface in the first direction.
Clause 8: The semiconductor device of any preceding clause, wherein a minimum thickness of the redistribution pattern on the first side surface ranges from about 0.1µm to about 0.5µm when viewed in cross-sectional view.
Clause 9: The semiconductor device of any preceding clause, wherein the opening further comprises a second side surface opposite to the first side surface, and
   wherein a first thickness of a first portion of the redistribution pattern on the first side surface is substantially equal to or greater than a second thickness of a second portion of the redistribution pattern on the second side surface when viewed in plan view.
Clause 10: The semiconductor device of any preceding clause, wherein the first corner region comprises a stepped shape when viewed in plan view.
Clause 11: The semiconductor device of any of clauses 1 to 10, wherein the first corner region comprises a chamfered edge when viewed in plan view.
Clause 12: The semiconductor device of any of clauses 1 to 10, wherein the first corner region comprises a curved surface that is convex toward an outside of the opening when viewed in plan view.
Clause 13: The semiconductor device of any of clauses 1 to 8, wherein the opening further comprises a second side surface opposite to the first side surface, and
   wherein the redistribution pattern on the first side surface and the redistribution pattern on the second side surface are asymmetrical about an axis extending in a second direction intersecting the first direction when viewed in plan view.
Clause 14: The semiconductor device of any of clauses 1 to 8, wherein the redistribution pattern comprises a recess on the bottom surface of the opening, and
   wherein the recess has an asymmetrical shape with respect to an axis extending perpendicular to the first direction when viewed in plan view.
Clause 15: The semiconductor device of any preceding clause, wherein the opening has comprises a shape that is elongated in the first direction or is elongated in a second direction intersecting the first direction
Clause 16: A semiconductor device comprising:
   an interconnection line;
   an insulating layer on the interconnection line and having an opening exposing a top surface of the interconnection line; and
   a redistribution pattern extending into the opening and electrically connected to the interconnection line at a bottom surface of the opening,
   wherein the opening comprises a first side surface facing a first direction, and a second side surface opposite to the first side surface, and
   wherein a first thickness of a first portion of the redistribution pattern on the first side surface is greater than a second thickness of a second portion of the redistribution pattern on the second side surface when viewed in plan view.
Clause 17: The semiconductor device of clause 16, wherein the interconnection line is configured to provide a current path in the first direction in a region adjacent to the redistribution pattern.
Clause 18: The semiconductor device of Clause 16 or 17, wherein the first portion of the redistribution pattern on the first side surface and the second portion of the redistribution pattern on the second side surface are asymmetrical about an axis extending in a second direction intersecting the first direction when viewed in plan view.
Clause 19: The semiconductor device of any of clauses 16 to 18, wherein the redistribution pattern comprises a recess on the bottom surface of the opening, and
   wherein the recess has an asymmetrical shape about an axis extending perpendicular to the first direction when viewed in plan view.
Clause 20: The semiconductor device of any of claims 16 to 19, wherein a first angle between the first side surface and the top surface of the interconnection line is less than a second angle between the second side surface and the top surface of the interconnection line when viewed in a cross-sectional view.
Clause 21: A semiconductor device comprising:
   an interconnection line;
   an insulating layer on the interconnection line and having an opening exposing a top surface of the interconnection line; and
   a redistribution pattern extending into the opening and electrically connected to the interconnection line at a bottom surface of the opening,
   wherein the opening comprises a first side surface facing a first direction, and a second side surface opposite to the first side surface, and
   wherein a first portion of the redistribution pattern on the first side surface and a second portion of the redistribution pattern on the second side surface are asymmetrical about an axis extending in a second direction intersecting the first direction when viewed in plan view.
Clause 22: The semiconductor device of clause 21, wherein the interconnection line is configured to provide a current path in the first direction in a region adjacent to the redistribution pattern.
Clause 23: The semiconductor device of clause 21 or 22, wherein a first thickness of the first portion of the redistribution pattern on the first side surface is greater than a second thickness of the second portion of the redistribution pattern on the second side surface when viewed in cross-sectional view.
Clause 24: The semiconductor device of any of clauses 21 to 23, wherein the redistribution pattern extends in the first direction when viewed in plan view.
Clause 25: The semiconductor device of any of clauses 21 to 23, wherein the redistribution pattern extends in a second direction intersecting the first direction when viewed in a plan view.
Clauses 26: A semiconductor device comprising:
   a semiconductor layer on a substrate; and
   an interconnection layer on the semiconductor layer,
   wherein the interconnection layer comprises:
      a lower insulating layer and a lower interconnection line in the lower insulating layer;
      an upper interconnection line on the lower interconnection line;
      an upper insulating layer on the upper interconnection line and having a first opening exposing a top surface of the upper interconnection line;
      a redistribution pattern extending into the first opening and electrically connected to the upper interconnection line at a bottom surface of the first opening; and
      a passivation layer on the redistribution pattern and having a second opening exposing a top surface of the redistribution pattern,
   wherein the upper interconnection line is configured to provide a current path in a first direction in a region adjacent to the redistribution pattern,
   wherein the first opening comprises a first side surface facing the first direction, and
   wherein a corner region of the first opening protrudes away from or is recessed towards the first opening at an end portion of the first side surface of the first opening when viewed in plan view.

## Claims

1. A semiconductor device comprising:
an interconnection line;
an insulating layer on the interconnection line and having an opening on a top surface of the interconnection line; and
a redistribution pattern extending into the opening and electrically connected to the interconnection line at a bottom surface of the opening,
wherein the interconnection line is configured to provide a current path in a first direction in a region adjacent to the redistribution pattern,
wherein the opening comprises a first side surface facing the first direction, and
wherein a first corner region of the opening protrudes away from or is recessed toward the opening at a first end portion of the first side surface of the opening when viewed in plan view.

2. The semiconductor device of claim 1, wherein a second corner region of the opening protrudes away from or is recessed toward the opening at a second end portion of the first side surface of the opening when viewed in plan view.

3. The semiconductor device of claim 1 or 2, wherein the opening further comprises a second side surface opposite to the first side surface, and
wherein the first side surface and the second side surface are symmetrical about an axis extending in the first direction.

4. The semiconductor device of claim 3, wherein a corner region of the opening protrudes away from or is recessed toward the opening at an end portion of the second side surface of the opening when viewed in plan view.

5. The semiconductor device of claim 1 or 2, wherein the opening further comprises a second side surface opposite to the first side surface, and
wherein the first side surface and the second side surface are asymmetrical about an axis extending in a second direction intersecting the first direction.

6. The semiconductor device of claim 5, wherein a corner region of the opening does not protrude away from or is not recessed toward the opening at an end portion of the second side surface of the opening when viewed in plan view.

7. The semiconductor device of any preceding claim, wherein the opening further comprises a second side surface opposite to the first side surface,
wherein the first corner region protrudes in a second direction intersecting the first direction, and
wherein a width of the first corner region in the first direction ranges from about 1% to about 40% of a distance between the first side surface and the second side surface in the first direction.

8. The semiconductor device of any preceding claim, wherein a minimum thickness of the redistribution pattern on the first side surface ranges from about 0.1µm to about 0.5µm when viewed in cross-sectional view.

9. The semiconductor device of any preceding claim, wherein the opening further comprises a second side surface opposite to the first side surface, and
wherein a first thickness of a first portion of the redistribution pattern on the first side surface is substantially equal to or greater than a second thickness of a second portion of the redistribution pattern on the second side surface when viewed in plan view.

10. The semiconductor device of any preceding claim, wherein the first corner region comprises a stepped shape when viewed in plan view.

11. The semiconductor device of any of claims 1 to 10, wherein the first corner region comprises a chamfered edge when viewed in plan view.

12. The semiconductor device of any of claims 1 to 10, wherein the first corner region comprises a curved surface that is convex toward an outside of the opening when viewed in plan view.

13. The semiconductor device of any of claims 1 to 8, wherein the opening further comprises a second side surface opposite to the first side surface, and
wherein the redistribution pattern on the first side surface and the redistribution pattern on the second side surface are asymmetrical about an axis extending in a second direction intersecting the first direction when viewed in plan view.

14. The semiconductor device of any of claims 1 to 8, wherein the redistribution pattern comprises a recess on the bottom surface of the opening, and
wherein the recess has an asymmetrical shape with respect to an axis extending perpendicular to the first direction when viewed in plan view.

15. A semiconductor device comprising:
a semiconductor layer on a substrate; and
an interconnection layer on the semiconductor layer,
wherein the interconnection layer comprises:
a lower insulating layer and a lower interconnection line in the lower insulating layer;
an upper interconnection line on the lower interconnection line;
an upper insulating layer on the upper interconnection line and having a first opening exposing a top surface of the upper interconnection line;
a redistribution pattern extending into the first opening and electrically connected to the upper interconnection line at a bottom surface of the first opening; and
a passivation layer on the redistribution pattern and having a second opening exposing a top surface of the redistribution pattern,
wherein the upper interconnection line is configured to provide a current path in a first direction in a region adjacent to the redistribution pattern,
wherein the first opening comprises a first side surface facing the first direction, and
wherein a corner region of the first opening protrudes away from or is recessed towards the first opening at an end portion of the first side surface of the first opening when viewed in plan view.
